**Europäisches Patentamt**

**European Patent Office**

**Office européen des brevets**

(19)

(11) Veröffentlichungsnummer: **0 012 393**
**A1**

(12) # EUROPÄISCHE PATENTANMELDUNG

(21) Anmeldenummer: **79105004.0**

(22) Anmeldetag: **07.12.79**

(51) Int. Cl.³: **H 03 H 15/02**

(30) Priorität: **13.12.78 DE 2853799**

(71) Anmelder: **SIEMENS AKTIENGESELLSCHAFT Berlin und München, Postfach 22 02 61, D-8000 München 22 (DE)**

(43) Veröffentlichungstag der Anmeldung: **25.06.80**
**Patentblatt 80/13**

(72) Erfinder: **Lüder, Rainer, Dr., Kohlstattstrasse 10, D-8024 Oberhaching (DE)**

(84) Benannte Vertragsstaaten: **FR GB**

(54) **Taktgesteuerte monolithisch integrierbare Abtastschaltung.**

(57) Die Erfindung bezieht sich auf eine in einem störunterdrückenden Nachrichtenübertragungssystem mit schmalbandiger konventioneller Nachrichtenmodulation und zusätzlicher pseudozufälliger Phasensprungmodulation (PN-PSK) vorgesehene Empfangsschaltung mit einem Pseudozufallsgenerator, dessen Pseudozufallsfolge identisch mit der empfangenen Pseudozufallsfolge ist und der einen die sendeseitig aufgebrachte Phasensprungmodulation rückgängig machenden Phasenumtaster (PU) betätigt, und mit einem angepaßten Filter oder Korrelationsnetzwerk zur Korrelation der empfängerseitig erzeugten Pseudozufallsfolge mit der im Empfangssignal enthaltenen Pseudozufallsfolge. Die Nachrichtenmodulation beeinträchtigt die Funktion des angepaßten Filters bzw. des Korrelationsnetzwerks. Es soll der störende Einfluß der Nachrichtenmodulation beseitigt, zumindest aber verringert werden. Die Erfindung sieht hierzu eine Entmodulationsschaltung (EM) vor, der einerseits das gesamte empfangene Signal und andererseits das nach der Phasenumtastung vorliegende Signal zugeführt wird und der zur Eingabe in das angepaßte Filter bzw. in das Korrelationsnetzwerk ein Signal entnommen wird, das nur noch die im Empfangssignal enthaltene pseudozufällige Phasensprungmodulation, nicht mehr jedoch die Nachrichtenmodulation aufweist. Eine erfindungsgemäße Empfangsschaltung ist zum Einsatz in störunterdrükkendem Spread-Spectrum-Nachrichtenübertragungssystem geeignet.

SIEMENS AKTIENGESELLSCHAFT          Unser Zeichen
Berlin und München                  VPA 78 P 1 2 1 9 EUR

Taktgesteuerte monolithisch integrierbare Abtastschaltung

Die Erfindung betrifft eine taktgesteuerte monolithisch
integrierbare Abtastschaltung, an deren Eingang das abzutastende und durch ein Vorfilter bandbegrenzte Analogsignal zu legen ist und die ein aus m parallelen Zweigen
bestehendes erstes Abtastsystem enthält, dessen Abtastwerte das Eingangssignal des eigentlichen zweiten Abtastsystems bilden.

Ein ähnliches System mit zwei Parallelzweigen im ersten
Abtastsystem ist in dem Aufsatz "Antialiasing inputs for
charge coupled devices" von C.H. Séquin in "Proceedings
of International Electronic Device Meeting, IEDM 76",
S. 31 - 34, beschrieben.

Bekanntlich kann man (vgl. z.B. Philips Technische Rundschau, 31 (1970/71) Nr.4, S. 97 - 111) Abtastschaltungen
in monolithisch integrierter Halbleitertechnik durch Ladungstransportelemente (CTD) realisieren. Dabei tritt jedoch erfahrungsgemäß das Problem auf, das Spektrum des
analogen Signals vor der Abtastung soweit zu begrenzen,

0012393

daß Faltungsprodukte, die in derartigen Abtastschaltungen zwangsläufig entstehen, sich im Spektrum des Ausgangssignals möglichst wenig bemerkbar machen sollen. Mit der Lösung der Aufgabe, die Entstehung von Faltungsprodukten zu unterdrücken, befassen sich die Ausführungen des oben genannten Aufsatzes sowie die Literaturstelle "Proceedings of International Conference CCD 76, Edinburgh, S. 302 - 308. Als Grundlage für die Ausführungen in den beiden Veröffentlichungen sowie auch für die vorliegende Beschreibung dienen vor allem Filter auf CCD-Grundlage, obwohl - wenigstens im Falle der Erfindung - auch eine Realisierung in BBD-Technik möglich ist.

Bei der Ausgestaltung eines zur Bandbegrenzung von Analogsignalen dienenden Filters (hier Vorfilter genannt) ist jedoch zu berücksichtigen, daß das Filter umso komplizierter und aufwendiger wird, je kleiner man bei einem vorgegebenen Anwendungsfall die Abtastfrequenz wählt, da diese bei der Bemessung des Vorfilters berücksichtigt werden muß. Andererseits führt die Verwendung einer niedrigeren Abtastfrequenz zu einem einfacheren Abtastsystem, da dann dessen Aufbau weniger Funktionselemente, insbesondere Speicherelemente, benötigt. Außerdem ist bei vielen Anwendungen aus technologischen Gründen eine möglichst niedrige Abtastfrequenz wünschenswert.

Da man andererseits, wie bereits angedeutet, ein einfaches und toleranzunempfindliches Vorfilter, schon im Interesse der monolithischen Integration (z.B. bei CTD-Filtern als RC-Netzwerk), als wünschenswert erachtet, wäre es günstig, eine Möglichkeit zur Verfügung zu haben, bei der trotz einfachen Aufbaus des Vorfilters eine befriedigende Unterdrückung des Einflusses von Faltungsprodukten auf das von der Abtastschaltung abgegebene Signal gewährleistet ist, ohne daß die Abtastfrequenz erhöht werden muß.

Erfindungsgemäß wird deshalb zur Lösung dieser Aufgabe vorgeschlagen, daß der Abtaster eines üblichen Abtastsystems durch ein erstes Abtastsystem ersetzt wird, das aus m Parallelzweigen mit je einem Abtaster, einer Verzögerungseinheit und einem Abtastfilter besteht, daß die Abtaster das durch das Vorfilter bandbegrenzte Eingangssignal mit derselben Taktfrequenz, die auch für das nachfolgende zweite Abtastsystem verbindlich ist, phasenverschoben abtasten, daß ferner die m zueinander phasenverschobenen Abtastwerte eine in den Parallelzweigen unterschiedliche Verzögerung durchlaufen, durch die die m Abtastwerte dieselbe Phasenlage erhalten, daß anschließend die Abtastwerte der m Parallelzweige jeweils einem der m Abtastfilter zugeführt werden, die so bemessen sind, daß Spektralanteile des Eingangssignals bis zum (m-1)-fachen der Taktfrequenz keine das Gesamtsystem störenden Faltungsprodukte erzeugen, und daß schließlich die Ausgangssignale der m Abtastfilter addiert werden und die dadurch entstehende Folge von Abtastwerten das Eingangssignal des eigentlichen - zweiten - Abtastsystems bilden.

Ist $A_r$ die zum Betrieb des Abtasters des r-ten Parallelzweiges vorgesehene Folge von Arbeitstakten und $A_s$ die zum Betrieb des Abtasters des s-ten Parallelzweiges dienende Folge von Arbeitstakten, so ist bevorzugt vorgesehen, daß die Zeitverschiebung $\Delta t$ zwischen den Einzeltakten der einen und den Einzeltakten der anderen Folge von Arbeitstakten durch die Beziehung

$$\Delta t = (r - s) \cdot T/m$$

gegeben ist, wobei T die durch die Abtastfrequenz, also die Frequenz der Abtasttakte, festgelegte und für alle Abtaster des ersten Abtastsystems verbindliche Taktperiode, r und s die Nummern der jeweils betrachteten Parallelzweige und m die Gesamtzahl der Parallelzweige des ersten Abtastsystems bedeuten. Ferner ist bevorzugt vorgesehen, daß in genau einem der insgesamt vorgesehenen Parallelzweige des ersten Abtastsystems das von dem Abtaster gelieferte Signal unverzögert an das zugehörige Abtastfilter weitergegeben wird.

Die m Abtastfilter sind vorzugweise nichtrekursive Filter, die mit Ladungstransportelementen vorteilhaft realisiert werden können. Die Bemessung dieser Filter kann mit Hilfe bekannter Syntheseverfahren für digitale Abtastfilter erfolgen.

Aufgrund einer in der beschriebenen Weise ausgestalteten Abtastschaltung ist auch bei Verwendung eines einfachen analogen Vorfilters die Reduktion der Abtastfrequenz um den Faktor 3 bis 6 bei vergleichbarer Dämpfung von Faltungsprodukten möglich, so daß man eine vorteilhaft in Verbindung mit CTD-Filtern einsetzbare, monolithisch integrierbare Halbleiter-Schaltungsanordnung zur Verfüfung hat. Zusammenfassend ist dabei folgendes festzustellen:

Das einer Anlage gemäß dieser Erfindung zugrundeliegende Prinzip sieht die Verwendung von m Abtastern für das Analogsignal vor, die m Folgen von Abtastwerten mit der Abtastperiode T liefern. Diese Folgen sind jeweils um die Zeit T/m zueinander versetzt. Nach der Abtastung erfolgt eine Zeitverzögerung für jede der Folgen in der Weise, daß alle Abtastwerte danach in Phase sind. Jede Folge wird einem gesonderten Filter zugeführt, das wiederum als Abtastfilter realisiert sein kann. Die m Ausgangsfolgen werden danach addiert und bilden eine neue Folge von Abtastwerten der Abtastfrequenz 1/T für das durch das zweite Abtastsystem gegebene eigentliche Abtastfilter.

Die m Filter in dem ersten Abtastsystem, das zusammen mit einem einfachen analogen Vorfilter/ein neues verbessertes Vorfilter für das eigentliche - zweite - Abtastsystem H darstellt, können aus der Zerlegung einer Filterfunktion

$H_o$ ermittelt werden, die ihrerseits als Abtastfilter mit der Taktfrequenz $m \cdot T^{-1}$ im Frequenzbereich $0 < f < m \cdot T^{-1}$ beschrieben werden kann und die mit üblichen Entwurfsverfahren sowohl für Tiefpaß- als auch für Bandpaß-Abtastsysteme H entworfen werden kann.

Bei einer Ausgestaltung in m-Phasen CTD-Technik wird man zweckmäßig m Folgen von Abtastwerten der Taktfrequenz $T^{-1}$ bilden, da die erforderlichen phasenverschobenen Taktsignale zum Betrieb einer solchen Anordnung sowieso benötigt werden. Die Zeitverzögerung der Abtastfolgen um den Betrag $i \cdot T/m$ mit $i = 1, 2, 3, \ldots (m-1)$ ist durch i Elektroden einer Halbleiter CTD-Anlage möglich. Die m Filter in dem ersten Abtastsystem sind als einfache Transversalfilter ebenfalls als CTD-Filter der Taktfrequenz $T^{-1}$ realisierbar.

Eine besonders günstige Ausgestaltung für die Filter des ersten Abtastsystems ergibt sich, wenn die zugehörigen Filterfunktionen $H_{ai}$ nur positive Koeffizienten aufweisen. In diesem Falle kann nämlich die Ladung eines Abtastwertes gewichtet aufgespalten und nach unterschiedlicher Verzögerung wieder addiert werden. Auch die Addition der an den Ausgängen dieser Abtastfilter sich pro Taktperiode T jeweils ergebenden Parallelsignale kann durch Zusammenführen der die betreffendenSignale darstellenden Ladungspakete im CTD erfolgen. Die Gesamtanordnung kann daher ohne zusätzliche Funktionselemente, z.B. Verstärker, in CCD-Technik zusammen mit dem durch das zweite Abtastsystem gegebenen Abtastfilter H integriert werden.

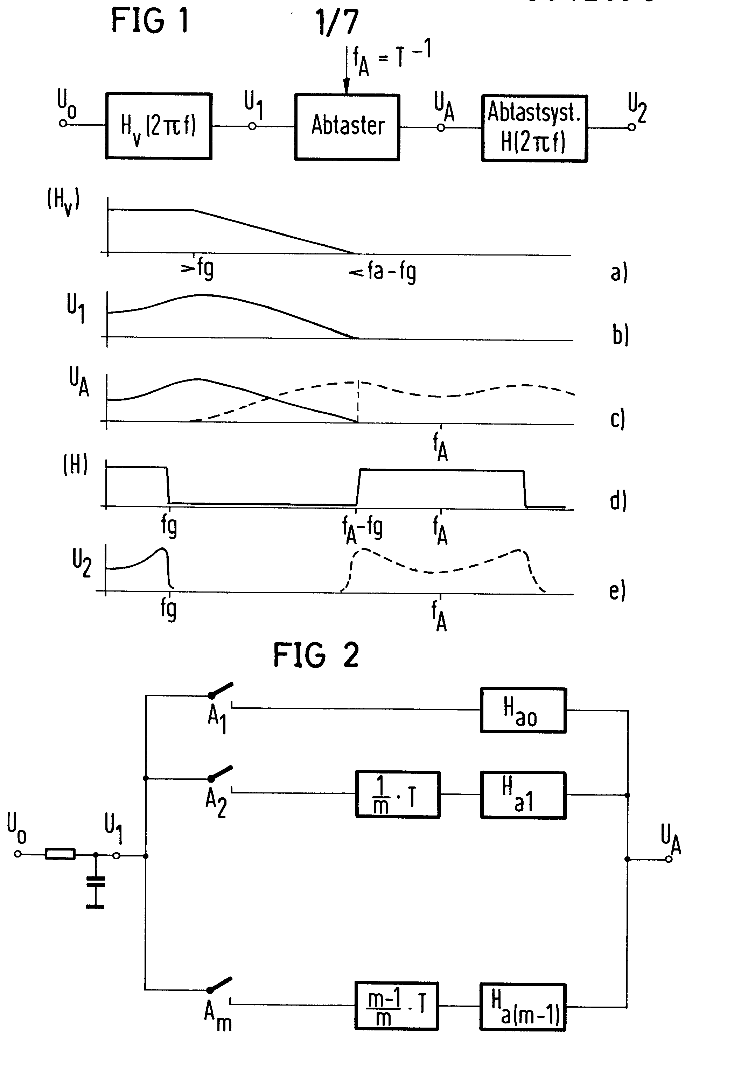

Die Erfindung wird nun anhand der Figuren 1 - 8 und der folgenden Darlegungen näher beschrieben.

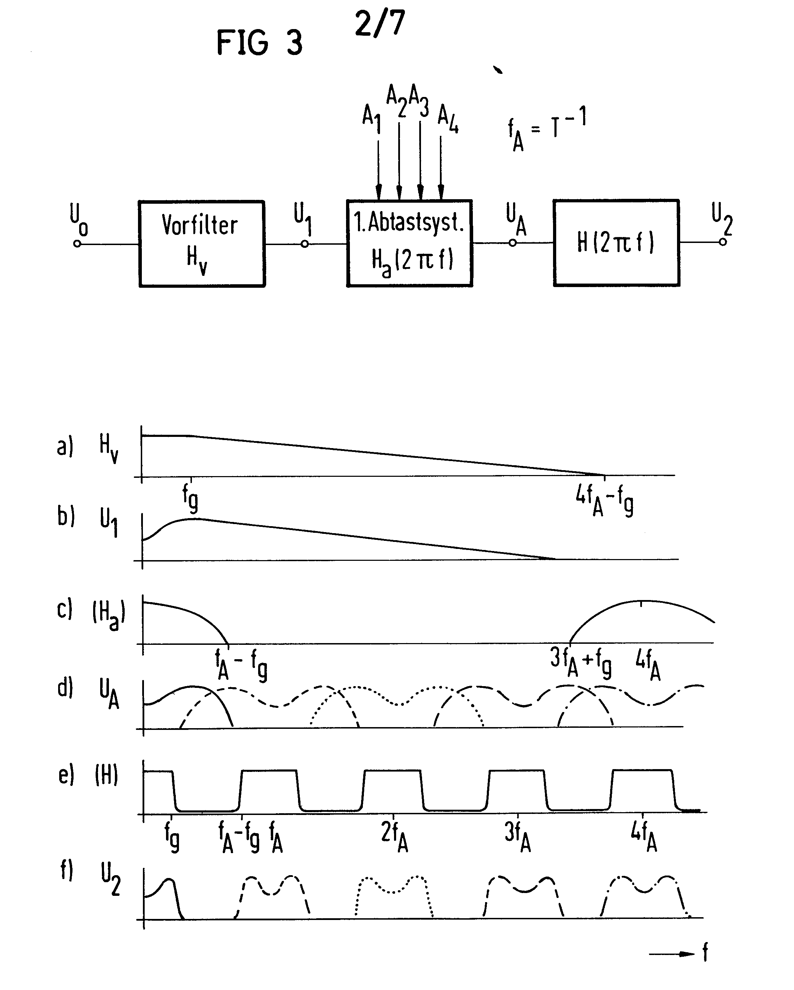

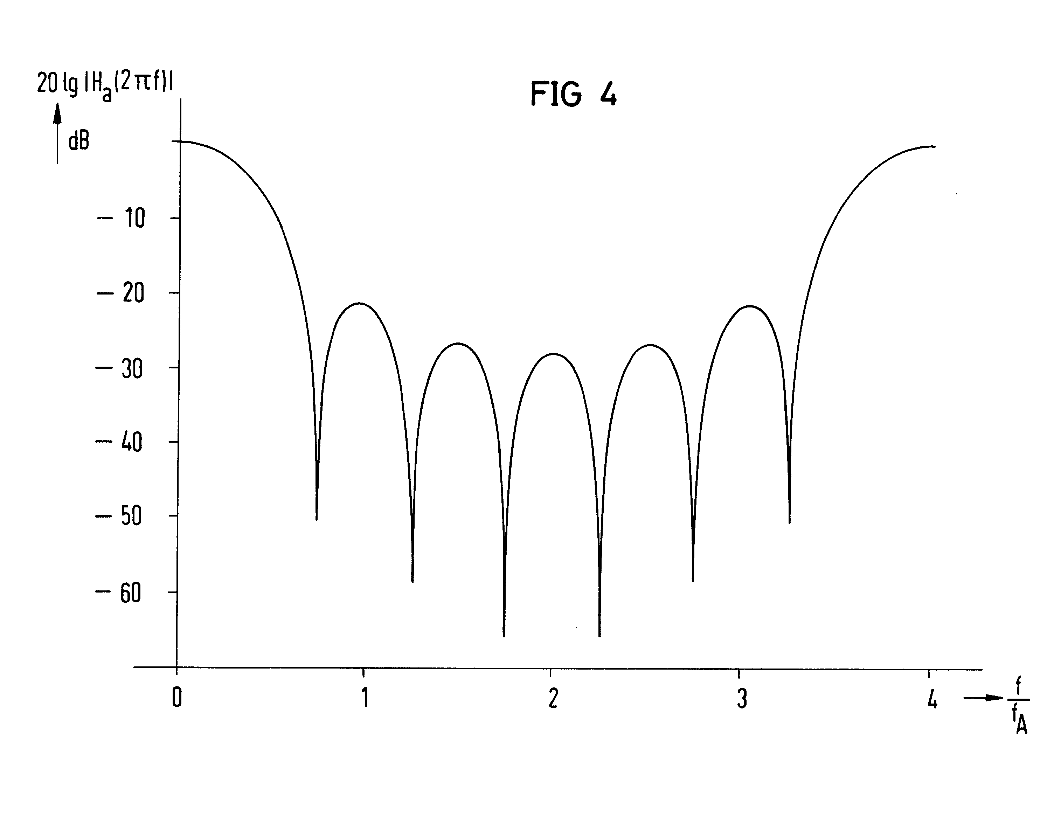

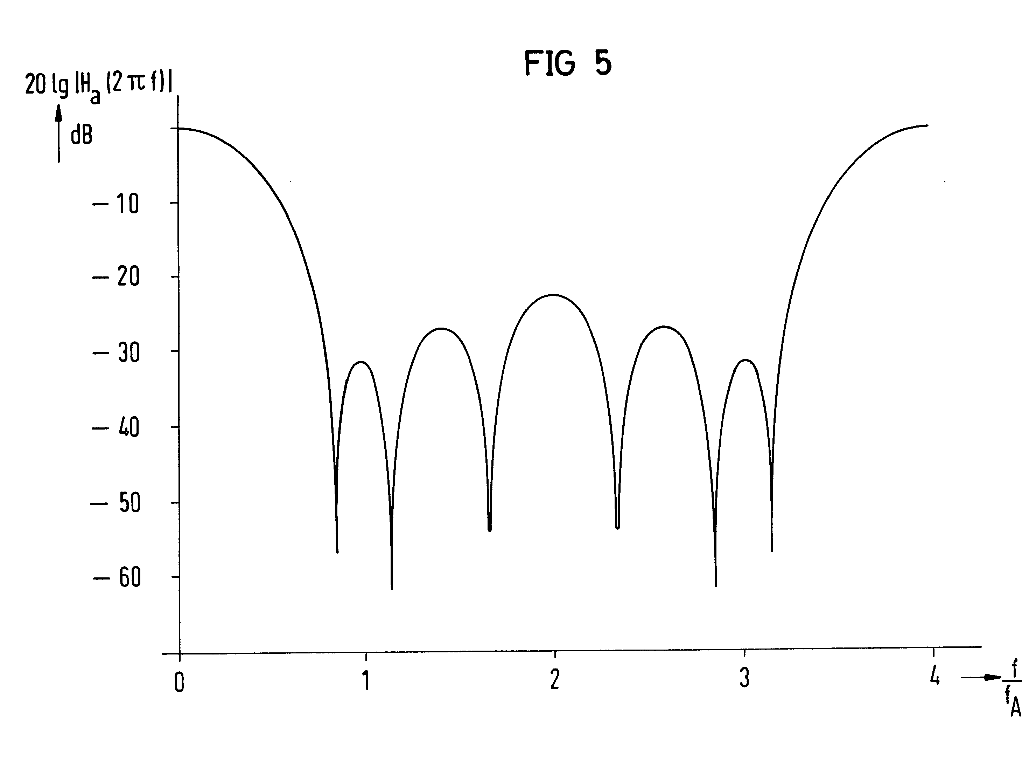

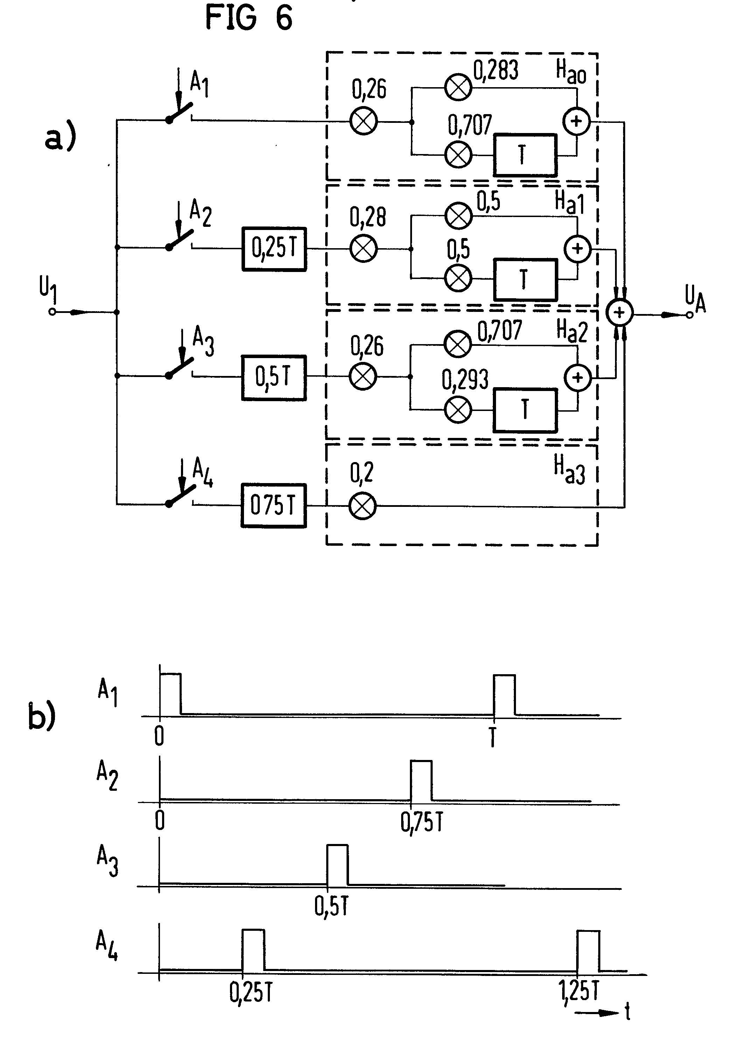

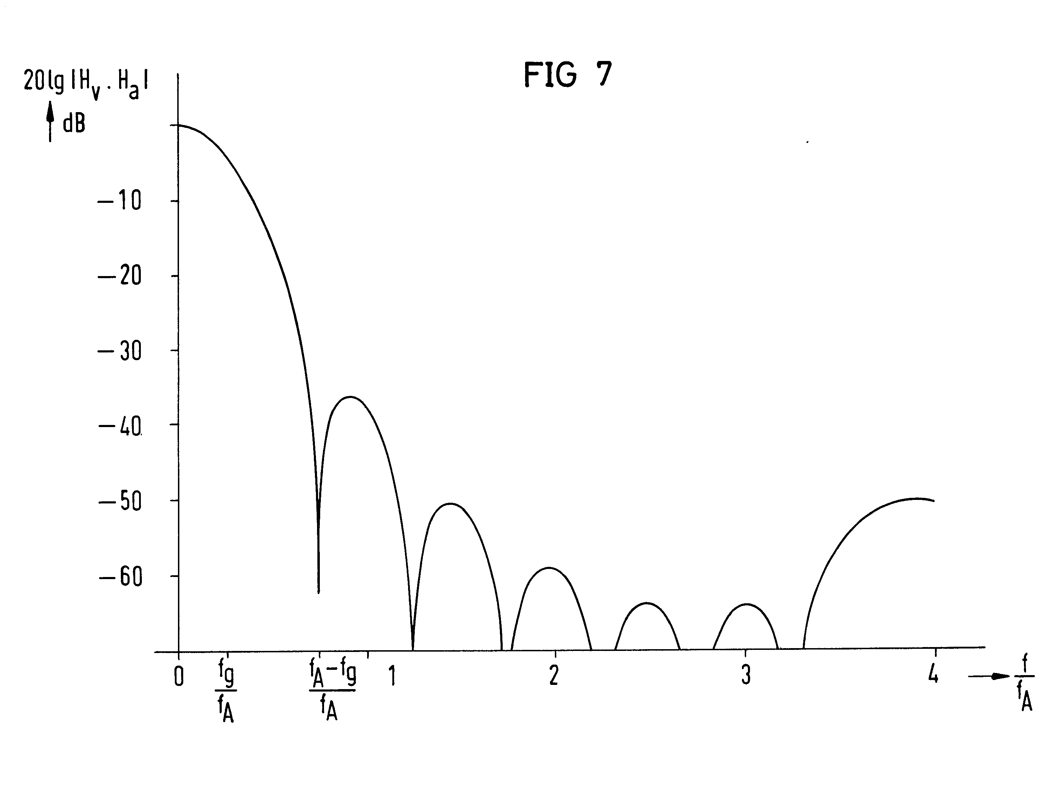

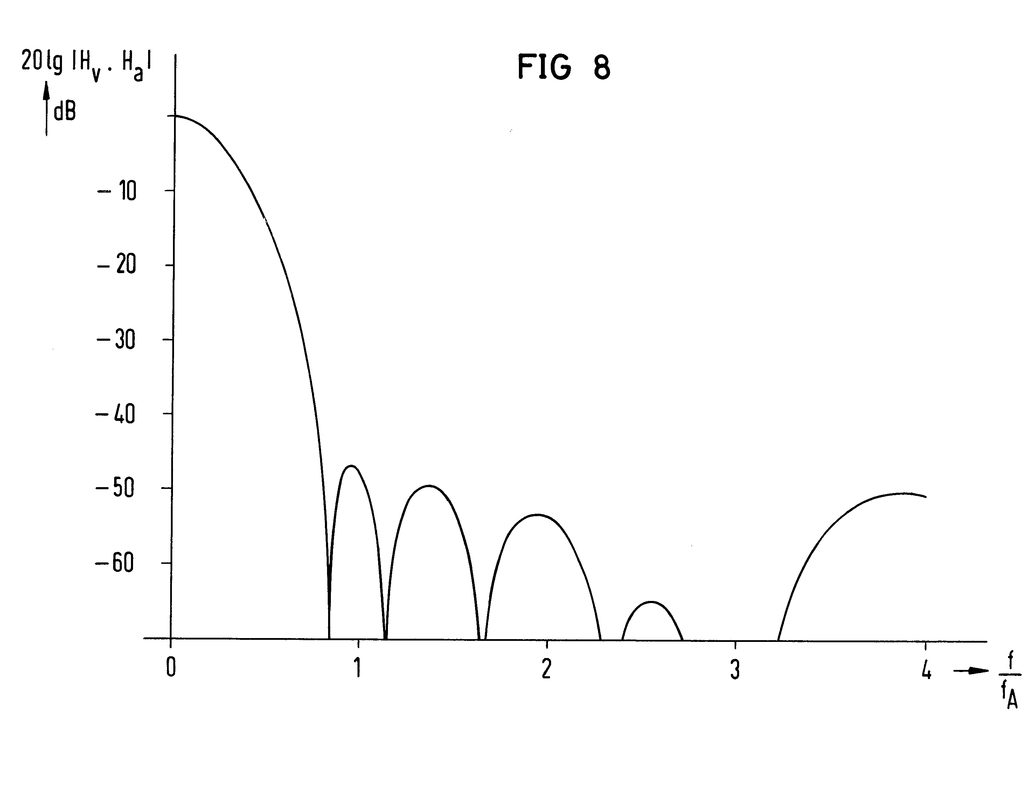

In Fig. 1 sind die bekannte Anordnung einer Abtastschaltung, bestehend aus dem Vorfilter, dem Abtaster und dem eigentlichen Abtastsystem sowie die zugehörigen Spektren dargestellt. In Fig. 2 ist der Aufbau des ersten Abtastungssystems bei einer Anordnung gemäß der Erfindung gezeigt, das den Abtaster in Fig. 1 ersetzt. In Fig. 3 ist eine Anordnung gemäß der Erfindung sowie die Folge der zugehörigen Spektren für m = 4 gezeigt. In Fig. 4 ist das Übertragungsverhalten in einem ersten Ausführungsbeispiel und in Fig. 5 in einem zweiten Beispiel einer Vorrichtung gemäß der Erfindung dargestellt. Fig. 6 zeigt die Ausführung des ersten Abtastsystems gemäß der Erfindung im Detail sowie die zugehörigen Taktphasen für das erste Beispiel und m=4. Fig. 7 zeigt das Verhalten des ersten Abtastsystems und eines Vorfilters für das erste Beispiel und Fig. 8 für das zweite Beispiel.

Eine Übertragungsfunktion $H^*(2\pi f)$ ($\pi$ = Kreiszahl) kann als Abtastfilter $H(2\pi f)$ mit einem CCD-Bauelement (CCD = Ladungsgekoppelte MOS-Halbleiterschaltung) realisiert werden, welche das von dem Vorfilter gelieferte Analogsignal $U_1(t)$ (t= Zeit) mit der Abtastfrequenz $f_A = T^{-1}$ abtastet. Die Übertragungsfunktion $H^*(2\pi f)$ muß dabei den Durchlaßbereich im Frequenzbereich $0 \leq f \leq f_A/2$ haben. Die obere Grenzfrequenz $f_g$ des Durchlaßbereiches sei dabei entsprechend der Bedingung $f_g < f_A/2$ gewählt.

Um Faltungsprodukte (aliasing) zu vermeiden, muß, wie aus Fig. 1 ersichtlich, das Spektrum des Analogsignals $U_o$ durch ein als Tiefpaß ausgebildetes Vorfilter $H_v(2\pi f)$ auf den Frequenzbereich $(f_A - f_g)$ begrenzt werden. Die Anforderungen an das als Analogfilter aufzubauende Vorfilter $H_v$ werden, wie bereits oben dargelegt, umso größer, je kleiner der Übergangsbereich zwischen dem Durchlaßbereich und dem Sperrbereich $(f_g \leq f \leq (f_A - f_g))$ des Vorfilters ist, d.h. je kleiner die Abtastfrequenz $f_A$ bei vorgegebener Grenzfrequenz $f_g$ gewählt wird. Andererseits benötigt das dem Vorfilter nachgeschaltete Abtastfilter umso weniger Elemente (Multiplikatoren, Verzögerungselemente) bei vorgegebenen Filtereigenschaften, je kleiner die Abtastfrequenz gewählt werden kann (Fig.1).

Durch ein erstes Abtastsystem der z.B. in CCD-Technik realisierten Anordnung, die Abtastung und Filterfunktion verbindet, ist es möglich, die Anforderungen an das Vorfilter $H_V$ soweit zu reduzieren, daß das Vorfilter durch ein unkritisches RC-Filter realisierbar ist und somit zusammen mit der CCD-Anordnung auf dem Halbleiterchip integriert werden kann. Eine Änderung der Abtastfrequenz ist dabei nicht erforderlich. Voraussetzung für diese Eingangsschaltung ist nur, daß m Taktphasen der Frequenz $f_A$ zur Verfügung stehen, was im allgemeinen schon für den Betrieb der CCD-Anordnung erforderlich ist. Die Taktphasen müssen jeweils um

$$\frac{1}{m \cdot f_A} = \frac{1}{m \cdot T}$$

zueinander versetzt sein. Beim 3-Phasen CCD sind demgemäß drei und beim 4-Phasen CCD vier solcher Taktphasen vorhanden.

Das erste Abtastsystem (Antialisingfilter) stellt bei vorgegebenem m eine Filterfunktion $H_a(2\pi f)$ dar, die als Abtastfilter mit der Taktfrequenz $f_A \cdot m$ entworfen werden kann. Ist die Übertragungsfunktion $H^*(2\pi f)$ ein Tiefpaß, so ist die Funktion und damit das erste Abtastsystem $H_a(2\pi f)$ ein Tiefpaß mit einem Sperrbereich bei $(f_A - f_g) \leq f \leq ((m-1) \cdot f_A + f_g)$. Ist die Übertragungsfunktion $H^*(2 \quad f)$ ein Bandpaß mit der Mittenfrequenz $f_o$ und der Bandbreite $B \ll f_o$, so genügt es, wenn das erste Abtastsystem eine Bandsperre bei $f_A - f_o$, $f_A + f_o$, ........, $(m-1) \cdot f_A - f_o$, $(m-1) \cdot f_A + f_o$ ist.

Entsprechend den Anforderungen wird das erste Abtastsystem mit den üblichen Verfahren der Filtersynthese als Abtastfilter entworfen. Ein Entwurf als nichtrekursives Filter ist günstig. Die Filterfunktion wird, wie üblich, als z-Transformierte beschrieben:

(1) $H_a(z') = a_o + a_1 z'^{-1} + a_2 z'^{-2} + \ldots + a_n z'^{-n}$.

Dabei ist

$$z = e^{i\omega t} \quad \text{und } z' = e^{i\omega T/m} = \sqrt[m]{z} \,,$$

worin $\omega$ die Kreisfrequenz, e die Basis der natürlichen Logarithmen und $i = \sqrt{-1}$ bedeutet.

Die Übertragungsfunktion $H_a(e^{i\ T/m})$ hat die Periode $m \cdot f_A$.

Ersetzt man z' durch z, so erhält man:

(2) $H_a(z) = a_o + a_1 z^{-1/m} + a_2 z^{-2/m} + \ldots + a_n z^{-n/m}$.

Diese Funktion kann, wie folgt, in eine Summe zerlegt werden:

(3) $H_a(z) = H_{ao}(z) + H_{a1}(z) \cdot z^{-1/m} + \ldots + H_{a(m-1)}(z) \cdot z^{-(m-1)/m}$

mit

(4) $H_{a\lambda} = a_\lambda + a_{m+\lambda} z^{-1} + a_{2m+\lambda} z^{-2} + \ldots + a_{km+\lambda} z^{-k}$

und $km \leqq n$, $a_{km+\lambda} = 0$ für $(km + \lambda) > n$, wobei $\lambda = 0, 1, 2, \ldots, (m-1)$.

Jede der Teilfilterfunktionen $H_a$ stellt somit ein nicht-rekursives Filter mit Verzögerungselementen T dar. Jede Teilfilterfunktion $H_a$ wird nach Gl. (4) um $\lambda \cdot T/m$ verzögert und die Summe aller $H_{a\lambda} \cdot z^{-1/m}$ gebildet.

Das als Antialiasingfilter wirkende erste Abtastsystem wird nun nicht mit der Taktfrequenz $m \cdot f_A$, sondern mit der Abtastfrequenz $f_A$ betrieben. Die Abtastung erfolgt zu den Zeitpunkten $t = (j-\lambda/m) \cdot T$, mit $j = -\infty \ldots + \infty$ und $\lambda = 0, 1, 2, \ldots, (m-1)$, wie dies in Fig. 2 dargestellt ist.

Die Faltungsprodukte der Frequenzen f, $(f_A - f_g) \leqq f \leqq [(m-1) \cdot f_a + f_g]$, die durch die Abtastung im Bereich $0 \leqq f \leqq f_A/2$ entstehen, sind entsprechend der Filterfunktion $H_a$ des ersten Abtastsystems soweit gedämpft, daß sie, wie aus Fig. 3 ersichtlich, nicht mehr stören.

Wie wiederholt festgestellt, stehen die benötigten m Taktphasen beim m-Phasen-CCD sowieso zur Verfügung. Die Verzögerung um $\lambda \cdot T/m$ ist durch $\lambda$ ($< m$) Elektroden auf dem betreffenden Parallelzweig des ersten Abtastsystems möglich. Die Teilfilter $H_{a\lambda}$ können als nichtrekursive Filter nach dem Ladungsverzweigungsprinzip und die Addition der Teilfilterausgänge, also der von den Parallelzweigen des ersten Abtastsystems pro Periode T abgegebenen Signale durch Ladungsaddition unter einer gemeinsamen Elektrode realisiert werden.

### Beispiel 1

Das Abtastfilter $H(2\pi f)$ sei ein Bandpaß mit der Mittenfrequenz $f_o$ und einer relativen Bandbreite $B/f_o = 0,01$. Die Abtastfrequenz sei $f_A = 4 f_o$. Wenn das erste Abtastsystem nicht entsprechend der vorliegenden Erfindung ausgestaltet ist, muß das Vorfilter $H_v(2\pi f)$ für diesen Fall eine Grenzfrequenz $f_g \geq f_o$ aufweisen und schon bei $(f_A - f_g) = 3 f_o$ eine hohe Dämpfung, z.B. von 40 dB, besitzen.

Bei einer Ausgestaltung des ersten Abtastsystems als Antialiasingfilter entsprechend der Erfindung für den Fall $m = 4$ hat man eine Bandsperre für die Frequenzen $3f_o$, $5f_o$, $7f_o$, $9f_o$, $11f_o$ und $13f_o$. Es hat die Funktion

$$H_a(z') = 0,0761 + 0,141\ z'^{-1} + 0,184\ z'^{-2} + 0,199\ z'^{-3} + 0,184\ z'^{-4} + 0,141\ z'^{-5} + 0,0761\ z'^{-6}.$$

Der Betrag $|H_a(2\pi f)|$ dieser Funktion ist in Fig. 4 dargestellt. Die Faltungsprodukte bei $3f_o$, $5f_o$, $7f_o$ usw. werden um mindestens 40 dB gedämpft. Das Vorfilter $H_v$ muß nunmehr erst bei $15f_o$ (statt bei $3f_o$) eine hohe Dämpfung besitzen. Das Vorfilter kann z.B. aus zwei RC-Gliedern mit $f_g = 0,5\ f_A$ bestehen, die einen Bestandteil eines Vorverstärkers bilden können. Wird ferner angenommen, daß der Abtastprozeß zwei weitere Zeitkonstanten

($\tau$ = 0,1 T und $\tau$ = 0,06 T) besitzt, so erhält man mit der soeben eingeführten Funktion $H_a(2\pi f)$ die in Fig. 7 dargestellte Dämpfung für die Faltungsprodukte, die wenigstens 40 - 50 dB beträgt, auch wenn $H_a(2\pi f)$ aufgrund der Toleranzen der Koeffizienten eine geringere Nullstellentiefe besitzt.

Fig. 6 zeigt das erste Abtastsystem einer Vorrichtung gemäß der Erfindung für dieses Beispiel, wobei in Fig. 6a die CCD-Struktur mit den üblichen Symbolen (vgl. z.B. die eingangs genannten beiden Literaturstellen "Proceedings of International Conference CCD 76, Edinburgh, S. 302 - 308, und "Poceedings of International Electronic Device Meeting, IEDM 76", S. 31 - 34) versehen ist.

Beispiel 2

Die Übertragungsfunktion $H^*(2\pi f)$ sei ein Tiefpaß mit der Grenzfrequenz $f_g$ = 0,2 $f_A$. Die Vorfilterung $H_v$ muß für $f \geq 0,8 f_A$ eine hohe Dämpfung, d.h. z.B. mehr als 40 dB, erreichen.

Das erste Abtastsystem einer Vorrichtung gemäß der Erfindung hat in diesem Fall für m = 4 die Funktion

$$H_a(z') = 0,071 + 0,122 z'^{-1} + 0,198 z'^{-2} + 0,218 z'^{-3} + $$
$$+ 0,198 z'^{-4} + 0,122 z'^{-5} + 0,071 z'^{-6}.$$

Diese Funktion hat Dämpfungspole bei 0,85 $f_A$, 1,15 $f_A$, 1,66 $f_A$, 2,34 $f_A$, 2,85 $f_A$ und 3,15 $f_A$. Fig. 7 zeigt die Funktion $H_a(2\pi f)$ für diesen Fall.

Mit einem Vorfilter $H_v$, das entsprechend Fig. 6a ausgestaltet und der soeben angegebenen Funktion entsprechend bemessen ist (2 RC-Glieder mit $f_g$ = 0,5 $f_A$ und zwei Zeitkonstanten $\tau$ = 0,1 T und $\tau$ = 0,06 T) erhält man die in Fig. 8 dargestellte Funktion für die Faltungsprodukte. Die Dämpfung ist für $f > 0,8\, f_A$ größer als 45 dB. Die CCD-Struktur ist, wie bereits festgestellt, bis auf die Koeffizienten dieselbe wie in Fig. 6. Die Dämpfung von 2,5 dB bei $f = f_g$ muß durch das das zweite Abtastsystem darstellende CCD-Filter $H(2\pi f)$ korrigiert werden.

Das zweite Abtastsystem $H(2\pi f)$ bildet bei einer Anordnung gemäß der Erfindung das eigentliche Abtastfilter, während das erste Abtastsystem die Aufgabe hat, die Faltungsprodukte zu dämpfen und auf diese Weise eine strukturelle Vereinfachung des Vorfilters $H_V$ zu ermöglichen. Das zweite Abtastsystem kann in üblicher Weise ausgestaltet sein, wobei sich wie bei allen derartigen Anlagen, die Realisierung als CCD-System, also als MIS-Halbleitersystem, vorzugsweise MOS-System mit entsprechenden Elektrodenmustern auf der den dotierten Halbleiterkristall der Anordnung bedeckenden $SiO_2$- oder sonstigen anorganischen Isolierschicht. Die verschiedenen Möglichkeiten der Ausgestaltung sind z.B. in "Elektroniker" Nr. 2/1978 S. EL 1 - El 6 angegeben.

8 Figuren

6 Patentansprüche

Patentansprüche

1. Taktgesteuerte monolithisch integrierbare Abtastschaltung, an deren Eingang das abzutastende und durch ein Vorfilter bandbegrenzte Analogsignal zu legen ist und die ein aus m parallelen Zweigen bestehendes erstes Abtastsystem enthält, dessen Abtastwerte das Eingangssignal des eigentlichen zweiten Abtastsystems bilden, dadurch gekennzeichnet, daß der Abtaster eines üblichen Abtastsystems durch ein erstes Abtastsystem ($H_a(2\pi f)$) ersetzt ist, das aus m Parallelzweigen mit je einem Abtaster ($A_1$, $A_2$,...$A_m$), einer Verzögerungseinheit ( T/m, 2T/m ,... (m-1)T/m) und einem Abtastfilter ($H_{ao}$, $H_{a1}$,... $H_{a(m-1)}$) besteht, daß die Abtaster ($A_1$, $A_2$,...$A_m$) das durch das Vorfilter ($H_v$) bandbegrenzte Eingangssignal mit derselben Taktfrequenz, die auch für das nachfolgende zweite Abtastsystem ($H(2\pi f)$) verbindlich ist, phasenverschoben abtasten, daß ferner die m zueinander phasenverschobenen Abtastwerte eine in den Parallelzweigen unterschiedliche Verzögerung durchlaufen, durch die die m Abtastwerte dieselbe Phasenlage erhalten, daß anschließend die Abtastwerte der m Parallelzweige jeweils einem der m Abtastfilter ($H_{ao}$,...$H_{a(m-1)}$) zugeführt werden, die so bemessen sind, daß Spektralanteile des Eingangssignals bis zum (m-1)-fachen der Taktfrequenz keine das Gesamtsystem störenden Faltungsprodukte erzeugen, und daß schließlich die Ausgangssignale der m Abtastfilter addiert werden und die dadurch entstehende Folge von Abtastwerten das Eingangssignal des eigentlichen - zweiten - Abtastsystems bilden.

2. Vorrichtung nach Anspruch 1, dadurch gekennzeichnet, daß die Zeitverschiebung zwischen den Einzeltakten der einen und den Einzeltakten der anderen Folge von Arbeitstakten durch die Beziehung $\Delta t = (r-s)\cdot T/m$ gegeben ist, wobei T die durch die Abtastfrequenz ($f_A$) festgelegte und für alle Abtaststufen des ersten Abtastsystems ($H_a(2\pi f)$) verbindliche Taktperiode sowie r und s die Nummern der jeweils betrachteten Parallelzweige und m die Gesamtzahl der Parallelzweige des ersten Abtastsystems $(H_a(2\pi f))$ bedeuten.

3. Vorrichtung nach Anspruch 1 oder 2, dadurch gekennzeichnet, daß in genau einem der insgesamt vorgesehenen Parallelzweige des ersten Abtastsystems $(H_a(2\pi f))$ das vom zugehörigen Abtaster $(A_o)$ gelieferte Signal unverzögert an das zugehörige Abtastfilter $(H_{ao})$ gelangt.

4. Vorrichtung nach den Ansprüchen 1 bis 3, dadurch gekennzeichnet, daß die beiden Abtastsysteme $(H_a(2\pi f)$, $H(2\pi f))$ in CCD-Technik realisiert und zusammen mit dem als Kombination von RC-Gliedern vorliegenden Vorfilter $(H_v)$ in einem gemeinsamen Halbleiterchip, insbesondere Siliciumchip, integriert sind.

5. Vorrichtung nach Anspruch 4, dadurch gekennzeichnet, daß der Abtaster durch eine an sich bekannte CCD-Eingangsschaltung realisiert ist, die das angelegte Signal $(U_1)$ in eine Ladung verwandelt, und daß die Transiversalfilter $(H_{a\lambda})$ mit Hilfe von gerichteter Ladungstrennung unterschiedlicher Verzögerung und Ladungsaddition gegeben sind.

6. Vorrichtung nach den Ansprüchen 1 bis 5, dadurch gekennzeichnet, daß das zweite Abtastsystem $(H(2\pi f))$ als ein - insbesondere mit derselben Abtastfrequenz $(f_T)$ wie das erste Abtastsystem $(H_a(2\pi f))$ betriebener - CCD-Abtaster ausgestaltet ist.

FIG 1    1/7    0012393

$f_A = T^{-1}$

$U_0$ — $H_v(2\pi f)$ — $U_1$ — Abtaster — $U_A$ — Abtastsyst. $H(2\pi f)$ — $U_2$

$(H_v)$

$>fg$    $<fa-fg$    a)

$U_1$    b)

$U_A$    $f_A$    c)

$(H)$    $fg$    $f_A-fg$    $f_A$    d)

$U_2$    $fg$    $f_A$    e)

FIG 2

$A_1$ — $H_{ao}$

$A_2$ — $\frac{1}{m} \cdot T$ — $H_{a1}$

$U_0$ — $U_1$

$A_m$ — $\frac{m-1}{m} \cdot T$ — $H_{a(m-1)}$

$U_A$

FIG 3

$f_A = T^{-1}$

a) $H_v$

$f_g$        $4f_A - f_g$

b) $U_1$

c) $(H_a)$

$f_A - f_g$       $3f_A + f_g$   $4f_A$

d) $U_A$

e) $(H)$

$f_g$   $f_A - f_g$   $f_A$     $2f_A$     $3f_A$     $4f_A$

f) $U_2$

$\longrightarrow f$

FIG 4

0012393

# FIG 5

FIG 6

a)

b)

FIG 7

FIG 8

$20 \lg |H_v \cdot H_a|$

$\uparrow$ dB

$-10$

$-20$

$-30$

$-40$

$-50$

$-60$

0    1    2    3    4    $\longrightarrow \dfrac{f}{f_A}$

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | NACHRICHTEN ELEKTRONIK, Band 31, Nr. 2, Februar 1977, Seiten 35-37 Heidelberg, DE. U. KROGMANN: "Kammfilter zur Ausblendung von Signalen vorgegebener Frequenzen und deren Harmonischen" <br><br> * Das ganze Dokument * <br><br> -- | 1-3 |
| | IEEE JOURNAL OF SOLID-STATE CIRCUITS, Band SC-12, Nr. 6, Dezember 1977, Seiten 642-649 New York, U.S.A. Y.A. HAQUE et al.: Design and Characterization of a Real-Time Correlator" <br><br> * Figur 9; Seite 646, linke Spalte, Zeile 23 - Seite 647, rechte Spalte, Zeile 16 * <br><br> -- | 4,5 |
| P | IEEE JOURNAL OF SOLID-STATE CIRCUITS, Band SC-14, Nr. 3, Juni 1979, Seiten 627-633 New York, U.S.A. Y.A. HAQUE et al.: "Distortion in Rotating Tap Weight Transversal Filters" <br><br> * Figur 3; Seite 628, linke Spalte, Zeile 28 - Seite 629, rechte Spalte, Zeile 9 * <br><br> -- | 1-3 |
| | FR - A - 2 349 236 (THOMSON-CSF) <br><br> * Figuren 3,11,14; Seite 3, Zeilen 19-30; Seite 9, Zeile 31 - Seite 12, Zeile 5 * <br><br> -- | 1-5 |
| A | US - A - 4 056 737 (C.H. SEQUIN) | 1 |

./.

KLASSIFIKATION DER ANMELDUNG (Int.Cl. 3)

H 03 H 15/02

RECHERCHIERTE SACHGEBIETE (Int. Cl. 3)

H 03 H 15/02
19/00

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 17-03-1980 | COPPIETERS |

| | EINSCHLÄGIGE DOKUMENTE | | KLASSIFIKATION DER ANMELDUNG (Int.Cl. 3) |
|---|---|---|---|
| Kategorie | Kennzeichnung des Dokuments mit Angabe, soweit erforderlich, der maßgeblichen Teile | betrifft Anspruch | |
| | * Das ganze Dokument *<br><br>---- | | |
| | | | RECHERCHIERTE SACHGEBIETE (Int. Cl. 3) |